# EUROPEAN PATENT APPLICATION

(11) **EP 1 184 879 A1**
(43) Date of publication of application: **06.03.2002**
(21) Application number: 00902916.6
(22) Date of filing: 10.02.2000
(51) Int. Cl.: H01B 1/06, H01B 5/14, C23C 14/06, C23C 14/34, G09F 9/00

(54) **CONDUCTIVE NITRIDE FILM, PROCESS FOR PRODUCING THE SAME, AND ANTIREFLECTION OBJECT**

(30) Priority: 10.02.1999 JP 3340999
(71) Applicant: ASAHI GLASS COMPANY LTD., Tokyo 100-8405 (JP)
(72) Inventor: FUJINO, Masami, Kanagawa 243-0406 (JP); SATO, Kazuo, Asahi Glass Company, Limited, Kanagawa 221-8755 (JP); MITSUI, Akira, Asahi Glass Company, Limited, Kanagawa 221-8755 (JP); TAKEDA, Satoshi, Asahi Glass Company, Limited, Kanagawa 221-8755 (JP); HORIE, Noritoshi, Asahi Glass Company, Limited, Chiba 273-0864 (JP)
(74) Representative: Müller-Boré & Partner Patentanwälte
(86) International application number: JP0000757
(87) International publication number: WO0048204

(57) **Abstract**

An excellent heat-resistant electroconductive nitride film containing Ti and/or Zr, and at least one metal selected from the group consisting of Al, Mo, Cr, Nb, Hf, Ni, Co, Fe, Pd, Ag, Au and Pt, its production method and an antireflector using the electroconductive nitride film.

## Description

### TECHNICAL FIELD

The present invention relates to an electroconductive nitride film, its production method, and an antireflector using the electroconductive nitride film.

### BACKGROUND ART

A titanium nitride film is used as an anti-static film for a cathode ray tube (CRT) and the like since it has an electroconductivity and an appropriate light-absorbing property. Also, a titanium nitride film is used as a heat-shielding film for a window glass of an automobile since it has a heat-shielding performance.

However, physical properties such as a specific resistivity of a titanium nitride film produced by a sputtering method are liable to vary depending on a remaining gas (mainly H₂O) pressure in a chamber, and therefore its physical properties tend to vary depending on a batch or a lot.

Accordingly, there was a problem that its productivity was not improved because an evacuation time had to be prolonged to remove the remaining gas.

Also, a resistance of the titanium nitride film was liable to vary by heat, and its heat resistance was not satisfactory. For example, when a multi-layered electroconductive reflection-preventing film using a titanium nitride film is formed on a CRT panel glass to prevent reflection on a CRT surface (viewer side surface), there is a problem that an electroconductivity is deteriorated by heat treatment at a temperature of around 450°C in the production process of CRT unless a special measure is taken.

Also, various reflection-preventing films are proposed in U.S.P. 5,091,244 and U.S.P. 5,407,733, but they provide a reflection-preventing performance against an incident light mainly from a film surface, and a reflection-preventing performance against an incident light from a substrate side (opposite side of the film surface) is not satisfactory.

An object of the present invention is to provide an electroconductive nitride film excellent in heat resistance. In the present invention, the expression "excellent in heat resistance" means "resistance change by heat is small". Further, another object of the present invention is to provide a method for producing an electroconductive nitride film, which enables the production of the electroconductive nitride film excellent in heat resistance in a high productivity.

Still further, other object of the present invention is to provide an excellent heat-resistant antireflector having an excellent reflection-preventing performance against an incident light from a substrate side (opposite side of the film surface) as well as an incident light from a film surface side.

### DISCLOSURE OF THE INVENTION

The present invention provides an electroconductive nitride film containing Ti and/or Zr, and at least one metal selected from the group consisting of Al, Si, Mo, Cr, Nb, Hf, Ni, Co, Fe, Pd, Ag, Au and Pt.

### BRIEF DESCRIPTION OF THE DRAWINGS

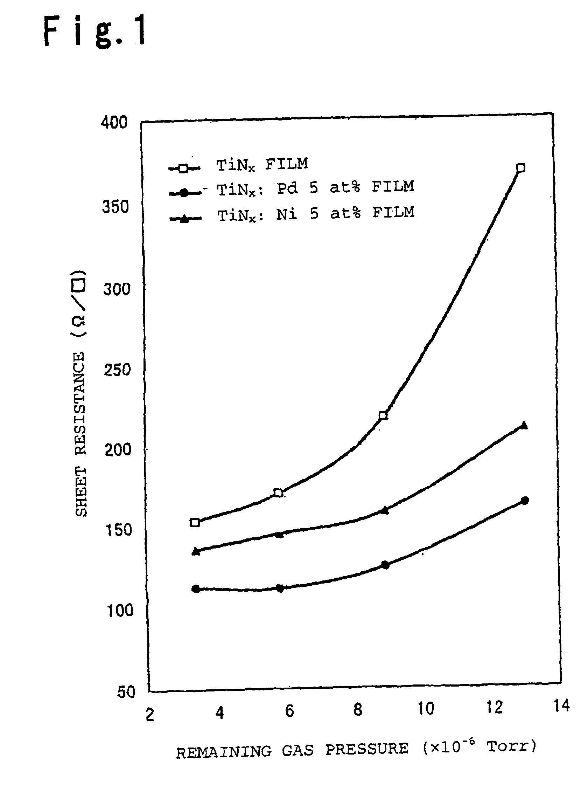

Fig. 1 is a graph showing a relationship between a sheet resistance and a remaining gas pressure of a film of TiNₓ, a film of TiNₓ: Pd 5 at%, and a film of TiNₓ: Ni 5 at%.

### BEST MODE FOR CARRYING OUT THE INVENTION

Hereinafter, "Ti and/or Zr" is simply referred to as "metal A" and "at least one metal selected from the group consisting of Al, Si, Mo, Cr, Nb, Hf, Ni, Co, Fe, Pd, Ag, Au and Pt" is simply referred to as "metal B".

Metal A in the electroconductive nitride film of the present invention is preferably Ti. In such a case, the electroconductive nitride film is a film comprising titanium nitride as the main component.

Also, preferable examples of metal B in the electroconductive nitride film of the present invention include at least one metal selected from the group consisting of Mo, Cr, Nb, Hf, Ni, Co, Fe, Pd, Ag and Pt. Particularly, at least one metal selected from the group consisting of Ni, Pd, Ag, Au and Pt is preferable. Further, at least one metal selected from the group consisting of Pd, Ag, Au and Pt is more preferable.

The electroconductive nitride film of the present invention has preferably a ratio of (total amount of metal B)/(total amount of metal A and metal B) in a range of from 0.1 to 20 at% (atom%). If the ratio is less than 0.1 at%, a remaining gas pressure dependency becomes large, and if the ratio exceeds 20 at%, a visible light transmittance becomes lower. Particularly, the ratio is preferably 1-10 at%.

In the present invention, the electroconductive nitride film may contain oxygen in such a minor amount as not to impair the effect of the present invention.

Also, the present invention provides an electroconductive nitride film (hereinafter referred to as "electroconductive nitride film C") containing Ti and/or Zr and at least one metal selected from the group consisting of Ni, Pd, Ag, Au and Pt, wherein a ratio of a total amount of Ni, Pd, Ag, Au and Pt to a total amount of Ti, Zr, Ni, Pd, Ag, Au and Pt is 0.1-20 at%.

Also, the present invention provides a method for producing an electroconductive nitride film by a sputtering process using a metal target containing metal A and metal B in a nitrogen-containing atmosphere.

When producing an electroconductive nitride film comprising titanium nitride as the main component, metal A in the metal target is preferably Ti.

Also, in the metal target in the present invention, preferable examples of metal B include at least one metal selected from the group consisting of Mo, Cr, Nb, Hf, Ni, Co, Fe, Pd, Ag and Pt. Particularly preferable examples include at least one metal selected from the group consisting of Ni, Pd, Ag, Au and Pt. More preferable examples include at least one metal selected from the group consisting of Pd, Ag, Au and Pt.

The metal target in the present invention is preferably a metal target having a ratio of a total amount of metal B to a total amount of metal A and metal B, i.e. (total amount of metal B)/(total amount of metal A and metal B), in a range of from 0.1 to 20 at%. A particularly preferable ratio is 1-10 at%.

Further, the present invention provides a method for producing an electroconductive nitride film C by a sputtering process in a nitrogen-containing atmosphere, using a metal target containing Ti and/or Zr, and at least one metal selected from the group consisting of Ni, Pd, Ag, Au and Pt, in which a ratio of a total amount of Ni, Pd, Ag, Au and Pt to a total amount of Ti, Zr, Ni, Pd, Ag, Au and Pt is 0.1-20 at%.

As the sputtering process, any of a radio-frequency (RF) sputtering process and a direct current (DC) sputtering process may be used. In view of productivity, a DC sputtering process is preferable. Also, as the sputtering atmosphere, a nitrogen gas-containing atmosphere, e.g. a mixed gas atmosphere of nitrogen gas and argon gas, may be preferably used.

Fig. 1 illustrates a relationship between a remaining gas pressure and a sheet resistance of 1) a titanium nitride film (TiNₓ film), 2) a titanium nitride film (TiNₓ: Pd 5 at% film) comprising titanium nitride as the main component and containing Pd (containing Pd only other than Ti), in which a ratio of Pd to a total amount of Pd and Ti is 5 at%, and 3) a titanium nitride film (TiNₓ: Ni 5 at% film) comprising titanium nitride as the main component and containing Ni (containing Ni only other than Ti), in which a ratio of Ni to a total amount of Ni and Ti is 5 at%.

The TiNₓ film was prepared by sputtering a Ti target in a mixture gas atmosphere of Ar:N₂=9:1 (volume ratio).

The TiNₓ: Pd 5 at% film was prepared by sputtering an alloy target of Ti and Pd (containing no Ni and containing Pd in an amount of 5 at% to a total amount of Ti and Pd) in a mixture gas atmosphere of Ar:N₂=9:1 (volume ratio).

The TiNₓ: Ni 5 at% film was prepared by sputtering an alloy target of Ti and Ni (containing no Pd and containing Ni in an amount of 5 at% to a total amount of Ti and Ni) in a mixture gas atmosphere of Ar:N₂=9:1 (volume ratio).

It is evident from Fig. 1 that a sheet resistance of the TiNₓ film largely varies by an influence of a remaining gas, whereas the TiNₓ: Pd 5 at% film and the TiNₓ: Ni 5 at% film are hardly influenced by a remaining gas.

In the present invention, a nitride film, for example, a Ti nitride film is expressed by TiNₓ, but this means that a nitride film to be obtained includes also a composition deviated from a stoichiometric composition. For example, depending on a film-forming condition, a Ti nitride film may sometimes become a reduced film wherein x is less than 1, and this tendency becomes large particularly when a dopant is contained as in the present invention.

A film thickness (geometrical film thickness) of the electroconductive nitride film of the present invention is preferably from 3 to 2,000 nm, and is determined depending on a desired sheet resistance and optical properties. If the film thickness is less than 3 nm, an electroconductivity and a heat-shielding performance are not satisfactory, and if the film thickness exceeds 2,000 nm, the film is easily separatable due to an internal stress. Particularly, the film thickness is more preferably from 5 to 500 nm.

A sheet resistance of the electroconductive nitride film of the present invention is preferably from 10 to 1,000 Ω/□ in view of electroconductivity and transmittance.

In the present invention, in order to control optical properties such as a reflectance, a transmittance and an absorbance, other nitride film, oxide film, metal film or the like may be laminated.

Also, it is possible 1) to form an oxide film or a nitride film on the electroconductive nitride film of the present invention in order to improve a mechanical durability and a chemical resistance, 2) to form an oxide film (such as silicon oxide film) or a nitride film (such as silicon nitride film) between a substrate and the electroconductive nitride film of the present invention in order to prevent elements or ions from diffusing when the elements or ions badly affecting the electroconductive nitride film are diffused into the electroconductive nitride film from the substrate on which the electroconductive nitride film is formed, and 3) to form an oxide film (such as silicon oxide film) or a nitride film (such as silicon nitride film) between a substrate and the electroconductive nitride film of the present invention in order to improve adhesion between the substrate and the electroconductive nitride film.

For example, it is possible to form a multi-layered low reflective electroconductive film particularly suitable to be used on a cathode ray tube panel surface by laminating firstly the electroconductive nitride film of the present invention and secondly a film of low refractive index (such as silica film) on a substrate.

Thus, the present invention also provides an antireflector having at least one layer of the electroconductive nitride film and at least one layer of a film of low refractive index formed on a substrate.

An antireflector of the simplest structure is an antireflector having firstly an electroconductive nitride film and secondly a film of a low refractive index formed on a substrate (hereinafter referred to as "two layer system antireflector").

A geometrical film thickness of the electroconductive nitride film in the two layer system antireflector is preferably from 5 to 40 nm (particularly 5 to 30 nm). The film of low refractive index preferably has a refractive index of at most 1.5 (particularly 1.35 to 1.5), an example of which includes a silica film. A geometrical film thickness of the film of low refractive index is preferably from 50 to 200 nm (particularly 65 to 120 nm).

In the two layer system antireflector, it is preferable to form a layer comprising a metal (including silicon also) as the main component or a layer comprising a metal nitride (including silicon nitride also) as the main component between the electroconductive nitride film and the film of low refractive index in order to stabilize a resistance value. This is called as a "barrier layer" which has substantially no optical meanings. Preferable examples of the barrier layer include a layer comprising silicon as the main component (such as a silicon layer) or a layer comprising silicon nitride as the main component (such as a transparent silicon nitride layer). A geometrical film thickness of the barrier layer is preferably from 1 to 20 nm.

Also, it is preferable to form a three layer system antireflector having a layer comprising silicon nitride as the main component (such as a transparent silicon nitride layer) as a third layer having an optical meaning (not a barrier layer) formed between the electroconductive nitride film and the film of low refractive index in the two layer system antireflector. A film thickness of the third layer is preferably from 30 to 70 nm.

Further, it is preferable to form a four layer system antireflector having an electroconductive nitride film of the present invention as a fourth layer having an optical meaning formed between the layer comprising silicon nitride as the main component and the layer of low refractive index in the three layer system antireflector. A film thickness of the fourth layer is preferably from 5 to 40 nm (particularly 5 to 30 nm).

The antireflector of the present invention reduces reflection of an incident light from a film of low refractive index. Also, since it has an electroconductivity, it has also an electromagnetic radiation-shielding property. Further, the antireflector has a light-absorbing property. Since the antireflector has the above-mentioned various performances, it is preferable as a display element provided on the viewer side.

Since the electroconductive nitride film in the antireflector has various satisfactory performances of controlling a transmittance, shielding an electromagnetic radiation and preventing reflection, it is important to maintain these performances of the electroconductive nitride film before and after heat treatment of the antireflector. From these viewpoints, metal B in the electroconductive nitride film is preferably at least one metal selected from the group consisting of Ni, Pd, Ag, Au and Pt. Particularly, at least one metal selected from the group consisting of Pd, Ag, Au and Pt is preferable.

The heat treatment applied to the antireflector should be preferably at most 550°C. When the antireflector of the present invention is applied to a cathode ray tube panel (i.e. an antireflector formed by laminating firstly an electroconductive nitride film and secondly a film of low refractive index on a glass panel), heat treatment is carried out at a temperature of 300 to 550°C (in the atmosphere) in the production process of a cathode ray tube, but the reflection-preventing performance is not impaired by the heat treatment.

It is preferable that a reflectance (average reflectance in a wavelength range of from 450 to 650 nm) to an incident light from the film side in the antireflector of the present invention is at most 3%. Also, it is preferable that a maximum reflectance (maximum reflectance in the wavelength range of from 450 to 650 nm) to an incident light from the substrate side (opposite side of the film side) is at most 15%.
Further, a film transmittance (not including a substrate) at 550 nm is preferably from 30 to 65%.

The present invention provides a display element having at least one layer of the above electroconductive nitride film and at least one layer of the above film of low refractive index formed to provide a display element having a reflection-preventing performance and a display having the above display element having the reflection-preventing performance.

The display element is an element constituting the front surface (the surface of viewer side) of a display. Examples of a substrate of the display element include a glass substrate, a plastic substrate, a plastic film and the like. More particular examples include a panel glass for CRT, a plastic film attached to the front surface of CRT for preventing reflection, and the like. Examples of the display include a CRT, a liquid crystal display, a plasma display, an EL (electroluminescence) display and the like.

### EXAMPLES

### EXAMPLE 1

A nitride film was formed on a glass substrate by sputtering a Ti target containing 5 at% of Pd (containing Pd only in addition to Ti) by means of a magnetron DC sputtering method under a remaining gas pressure of 1.3×10⁻⁵ torr (1.73×10⁻³ Pa) (the remaining gas pressure is larger and the remaining gas amount is larger as compared with a conventional pressure of about 5×10⁻⁶ torr (6.65×10⁻⁴ Pa)) at a power density of 2.2 W/cm² in a mixture gas atmosphere of Ar:N₂=9:1 (volume ratio) (6 mmtorr (798 mmPa)). The nitride film thus obtained was a titanium nitride film (TiNₓ: Pd 5 at% film) containing Pd in an amount of 5 at% and having a film thickness of 20 nm.

With regard to the nitride film thus obtained, a sheet resistance (Rₛ), a resistance variation between batches when film-formation was carried out five times (5 batches), and a resistance change after heat resistance test (250°C, 30 minutes) were measured. The results are shown in the following Table 1.

### EXAMPLE 2

A nitride film was formed in the same manner as in Example 1 except that a Ti target containing Ni in an amount of 5 at% (containing Ni only in addition to Ti) was used in place of the target used in Example 1. The nitride film thus obtained was a titanium nitride film (TiNₓ: Ni 5 at% film) containing Ni in an amount of 5 at% and having a film thickness of 20 nm. The same measurement was carried out in the same manner as in Example 1. The results are shown in the following Table 1.

### EXAMPLE 3

A nitride film was formed in the same manner as in Example 1 except that a Ti target was used in place of the target used in Example 1. The nitride film thus obtained was a titanium nitride film (TiNₓ film) having a film thickness of 20 nm. The same measurement was carried out in the same manner as in Example 1. The results are shown in the following Table 1.

As evident from Table 1, the TiNₓ: Pd 5 at% film and the TiNₓ: Ni 5 at% film of the present invention had less resistance change between batches and less resistance change by heat resistance test, and were proved to have satisfactory reproducibility and heat resistance, as compared with the TiNₓ film.

**Table 1**

| Example | Rₛ (Ω/□) | Resistance change between batches | Resistance change by heat resistance test |
|---|---|---|---|
| 1 | 163 | ±2% | +2% |
| 2 | 210 | ±3% | +4% |
| 3 | 368 | ±15% | +30% |

### EXAMPLE 4

A titanium nitride film containing Pd in an amount of 3 at% (TiNₓ: Pd 3 at% film) was formed on a CRT panel glass surface (viewer side surface) in the same manner as in Example 1, except that a Ti target containing Pd in an amount of 3 at% (containing Pd only in addition to Ti) was used so as to have a film thickness of 10 nm.

A silica film having a thickness of 90 nm was formed on the above formed titanium nitride film under conditions of a back pressure of 5.0×10⁻⁵ torr (6.65×10⁻³ Pa), oxygen 100% and a power density of 3.9 W/cm² to obtain a CRT panel glass having a reflection-preventing performance. The panel glass thus obtained had a surface resistance of 330 Ω/□, a satisfactory electromagnetic radiation-shielding performance, a luminance reflectance of 0.4% as a measure for reflection-preventing performance, and a visible light transmittance of 75%.

In the formation of the titanium nitride film, a remaining gas pressure was about 3×10⁻⁵ torr (3.99×10⁻³ Pa) at the time of introducing a reaction gas.

Heretofore, in order to form a titanium nitride film (film thickness 10 nm) having a surface resistance of 700 Ω/□ for achieving an electromagnetic radiation-shielding performance by a reactive sputtering method, it was necessary to make a high vacuum state of a back pressure of at most 5×10⁻⁶ torr (6.65×10⁻⁴ Pa) at the time of introducing a reaction gas. This is because an excess amount of oxygen is incorporated into the titanium nitride film obtained and a film of low resistance can not be obtained if a remaining oxygen amount is large at the initiation of film formation. Therefore, it was conventionally necessary to evacuate for preparing a vacuum state for 2 to 3 hours until the initiation of the production.

On the other hand, in the present Example, a surface resistance of at most 700 Ω/□ could be obtained by making a back pressure of about 3×10⁻⁵ torr (3.99×10⁻³ Pa) at the time of introducing a reaction gas, and the evacuation time of making a vacuum state was reduced to a shorter time of about 30 minutes.

A CRT was produced by using the above obtained CRT panel glass having a reflection-preventing performance. In the production of the CRT, after heat treatment at a temperature of around 450°C for about 1 hour, a surface resistance of the panel glass was 350 Ω/□, and its resistance value variation was in an allowable range.

The above results are shown in the following Table 2. In Table 2, "before heat treatment" means a surface resistance value of a panel glass before heat treatment at a temperature of around 450°C for about 1 hour in the production of a CRT, and "after heat treatment" means a surface resistance value of a panel glass after heat treatment, and "change rate" means a surface resistance value change (resistance value after heat treatment/resistance value before heat treatment). The unit of the surface resistance values is Ω/□.

### EXAMPLE 5

A CRT was produced in the same manner as in Example 4, except that the titanium nitride film (TiNₓ: Pd 3 at% film) having a thickness of 10 nm in Example 4 was replaced by various nitride films having a thickness of 12 nm as shown in the following Table 2. The composition of each target employed was substantially the same as the composition of each film obtained.

The results are shown in the following table 2. In Table 2, "(Ti, Zr) Nₓ: Ni 3 at% film" means a nitride film of Ti and Zr containing Ni in an amount of 3 at%. For comparison, a TiNₓ film formed by using a Ti metal target is shown as a Comparative Example.

**Table 2**

| Kind of nitride film | Before heat treatment | After heat treatment | Change rate |
|---|---|---|---|
| TiNₓ: Pd 3 at% film | 330 | 350 | 1.1 times |
| TiNₓ: Mo 3 at% film | 360 | 500 | 1.4 times |
| TiNₓ: Ni 10 at% film | 340 | 410 | 1.2 times |
| TiNₓ: Cr 2.5 at% film | 410 | 530 | 1.3 times |
| TiNₓ: Fe 15 at% film | 360 | 500 | 1.4 times |
| TiNₓ: Ag 5 at% film | 310 | 320 | 1.0 times |
| TiNₓ: Au 3 at% film | 310 | 320 | 1.0 times |
| TiNₓ: Pt 2 at% film | 320 | 340 | 1.1 times |
| TiNₓ: Al 7 at% film | 400 | 570 | 1.4 times |
| TiNₓ: Si 12 at% film | 460 | 630 | 1.4 times |
| ZrNₓ: Pd 2 at% film | 360 | 370 | 1.0 times |
| ZrNₓ: Ni 7.5 at% film | 380 | 460 | 1.2 times |
| ZrNₓ: Nb 11 at% film | 410 | 530 | 1.3 times |
| (Ti, Zr) Nx: Ni 3 at% film | 370 | 440 | 1.2 times |
| TiNₓ film | 350 | 750 | 2.1 times |
| ZrNₓ film | 400 | 870 | 2.2 times |

### EXAMPLE 6

Each of a Ti target containing Pd in an amount of 2 at% (containing Pd only in addition to Ti), a polycrystalline silicon target, and a plasma-sprayed silicon target was placed on a cathode, and a vacuum tank was evacuated to 2×10⁻⁵ torr (2.66×10⁻³ Pa).

In accordance with a magnetron DC sputtering method, a titanium nitride film containing Pd in an amount of 2 at% (first layer, film thickness 12 nm), a transparent silicon nitride film (second layer, film thickness 40 nm), a titanium nitride film containing Pd in an amount of 2 at% (third layer, film thickness 8 nm), and a silica film (fourth layer, film thickness 85 nm) were formed in this order on a CRT panel glass surface (viewer side surface).

The first layer was formed under a pressure of 4.5×10⁻³ torr (5.99×10⁻¹ Pa) by using a Ti target containing Pd in an amount of 2 at% and introducing a mixture gas of Ar:N₂=80:20 (volume ratio) into the vacuum tank.

The second layer was formed under a pressure of 4×10⁻³ torr (5.32×10⁻¹ Pa) by evacuating after forming the first layer and by using a polycrystalline silicon target and introducing a mixture gas of Ar:N₂=70:30 (volume ratio) into the vacuum tank.

The third layer was formed under the same conditions as in the formation of the first layer by evacuating after forming the second layer.

The fourth layer was formed under a pressure of 4×10⁻³ torr (5.32×10⁻¹ Pa) by evacuating after forming the third layer and by using a plasma-sprayed silicon target and introducing a mixture gas of Ar:N₂=70:30 (volume ratio) into the vacuum tank.

The CRT panel glass having the multi-layered reflection-preventing film thus obtained was measured with regard to 1) a reflectance to an incident light from the film surface side (reflectance at a wavelength of 500 nm, hereinafter referred to as "reflectance of film surface"), 2) an average reflectance to an incident light from the film surface side (average reflectance in a wavelength range of 450 to 650 nm, hereinafter referred to as "average reflectance of film surface"), 3) a maximum reflectance to an incident light from the film surface side (maximum reflectance in a wavelength range of 450 to 650 nm, hereinafter referred to as "maximum reflectance of film surface"), 4) a reflectance to an incident light from the glass substrate side (opposite side of the film surface) (reflectance at a wavelength of 500 nm, hereinafter referred to as "reflectance of backside surface"), 5) an average reflectance to an incident light from the glass substrate side (average reflectance in a wavelength range of 450 to 650 nm, hereinafter referred to as "average reflectance of backside surface"), 6) a maximum reflectance to an incident light from the glass substrate side (maximum reflectance in a wavelength range of 450 to 650 nm, hereinafter referred to as "maximum reflectance of backside surface"), 7) a film transmittance (transmittance at 550 nm not containing a substrate), and 8) a surface resistance value. The same measurement was carried out with regard to the above items 1) to 8) after heat treatment at 450°C for 1 hour in the air atmosphere in the same manner as in the heat history in the production step of a CRT. The results are shown in the following Table 3.

Also, as a Comparative Example, a CRT panel glass having a multi-layered reflection-preventing film was obtained in the same manner as above, except that an ordinary titanium nitride film was formed (formed by using a Ti target) as the first layer and the third layer in place of the titanium nitride film containing Pd in an amount of 2 at% (TiNₓ: Pd 2 at% film), and the CRT panel glass having the multi-layered reflection-preventing film thus obtained was measured with regard to the above items 1) to 8). The results are shown in the following Table 3 as "Comparative Example of Example 6".

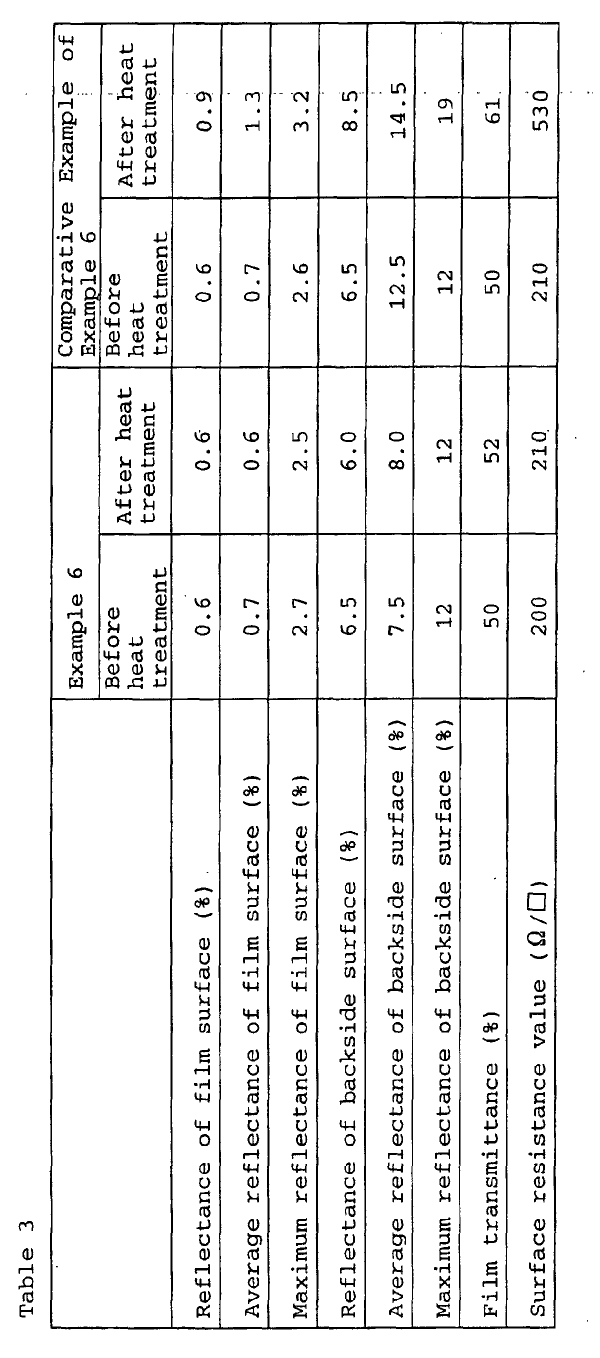

### EXAMPLE 7

A reflection-preventing film of four layers was formed on a CRT glass panel in the same manner as in Example 6, except that each film as shown in the following Table 4 was used in place of the TiNₓ: Pd 2 at% film of the first layer and the third layer. The composition of each target used for forming each film was substantially the same as the composition of each nitride film.

The various samples thus obtained were measured with regard to an average reflectance of film surface (%), a maximum reflectance of backside surface (%) and a surface resistance (Ω/□) before and after heat treatment at 450°C for 1 hour in the air atmosphere. The results are shown in the following Table 4. For comparison, a ZrNₓ film formed by using a Zr target was evaluated.

In Table 4, "(Ti, Zr) Nₓ: Pd 3 at% film" contains Zr in an amount of 18 at% to a total amount of Ti and Zr. "(Ti, Zr) Nₓ: Ni 5 at% film" contains Zr in an amount of 35 at% to a total amount of Ti and Zr. "(Ti, Zr) Nₓ: Au 3 at% film" contains Zr in an amount of 60 at% to a total amount of Ti and Zr.

### INDUSTRIAL APPLICABILITY

According to the production method of the present invention, reproducibility of a resistance is excellent even when film-formation is carried out in an atmosphere containing a large amount of a remaining gas, and productivity is satisfactory. Thus, an evacuation time for preparing a vacuum state can be reduced, thereby largely improving productivity.

Since the electroconductive nitride film of the present invention is excellent in heat resistance, it is suitably used as an antistatic film, a heat-shielding film, an electromagnetic radiation-shielding film or the like.

Also, the antireflector of the present invention is excellent in reflection-preventing property and electroconductivity and also has a satisfactory light-absorbing property, and it is therefore suitably used as a panel glass for CRT.

## Claims

1. An electroconductive nitride film containing Ti and/or Zr, and at least one metal selected from the group consisting of Al, Si, Mo, Cr, Nb, Hf, Ni, Co, Fe, Pd, Ag, Au and Pt.

2. The electroconductive nitride film according to Claim 1, wherein a ratio of a total amount of Al, Si, Mo, Cr, Nb, Hf, Ni, Co, Fe, Pd, Ag, Au and Pt to a total amount of Ti, Zr, Al, Si, Mo, Cr, Nb, Hf, Ni, Co, Fe, Pd, Ag, Au and Pt is 0.1-20 at%.

3. An electroconductive nitride film containing Ti and/or Zr, and at least one metal selected from the group consisting of Ni, Pd, Ag, Au and Pt, in which a ratio of a total amount of Ni, Pd, Ag, Au and Pt to a total amount of Ti, Zr, Ni, Pd, Ag, Au and Pt is 0.1-20 at%.

4. A method for producing the electroconductive nitride film as defined in Claim 1, which comprises using a metal target containing Ti and/or Zr, and at least one metal selected from the group consisting of Al, Si, Mo, Cr, Nb, Hf, Ni, Co, Fe, Pd, Ag, Au and Pt, and sputtering in a nitrogen-containing atmosphere.

5. The method for producing the electroconductive nitride film according to Claim 4, wherein the metal target used is a metal target containing Ti and/or Zr, and at least one metal selected from the group consisting of Al, Si, Mo, Cr, Nb, Hf, Ni, Co, Fe, Pd, Ag, Au and Pt, wherein a ratio of a total amount of Al, Si, Mo, Cr, Nb, Hf, Ni, Co, Fe, Pd, Ag, Au and Pt to a total amount of Ti, Zr, Al, Si, Mo, Cr, Nb, Hf, Ni, Co, Fe, Pd, Ag, Au and Pt is 0.1-20 at%.

6. A method for producing the electroconductive nitride film as defined in Claim 3, which comprises using a metal target containing Ti and/or Zr, and at least one metal selected from the group consisting of Ni, Pd, Ag, Au and Pt, wherein a ratio of a total amount of Ni, Pd, Ag, Au and Pt to'a total amount of Ti, Zr, Ni, Pd, Ag, Au and Pt is 0.1-20 at%, and sputtering in a nitrogen-containing atmosphere.

7. An antireflector having at least one layer of the electroconductive nitride film as defined in Claim 1, 2 or 3, and at least one layer of a low refractive index film, on a substrate.

8. A display element having a reflection-preventing performance, which has at least one layer of the electroconductive nitride film as defined in Claim 1, 2 or 3, and at least one layer of a low refractive index film, on a display element.

9. A display having the display element having a reflection-preventing performance as defined in Claim 8.
